# EUROPÄISCHE PATENTSCHRIFT

(11) **EP 2 690 412 B1**
(45) Veröffentlichungstag und Bekanntmachung des Hinweises auf die Patenterteilung: **18.04.2018**
(21) Anmeldenummer: 12177898.9
(22) Anmeldetag: 25.07.2012
(51) Int. Cl.: G01D 11/24

(54) **Sensor**
Sensor
Capteur

(43) Veröffentlichungstag der Anmeldung: 29.01.2014
(73) Patentinhaber: Baumer Electric AG, 8501 Frauenfeld (CH)
(72) Erfinder: Schwendimann, Mathias, 8212 Neuhausen (CH); Hohloch, Erich, 8355 Aadorf (CH)
(74) Vertreter: Strauss, Steffen

(56) Entgegenhaltungen:
- WO-A1-99/40285
- WO-A1-2012/080778
- DE-A1-102008 040 156
- DE-C1- 19 544 815
- DE-C2- 10 013 218
- US-A1- 2007 103 451

## Beschreibung

Die vorliegende Erfindung betrifft einen Sensor gemäß Anspruch 1 und ein Verfahren zur Herstellung eines Sensors gemäß Anspruch 13. Sensoren, zum Beispiel optische, induktive oder kapazitive Sensoren, werden in den verschiedensten technischen Anwendungen zur Erfassung von physikalischen oder chemischen Parametern eingesetzt. Das Gehäuse dient dazu, um Elektronikkomponenten auf einer Leiterplatte sowie ein Sensorelement vor schädigenden Umwelteinflüssen zu schützen. Die Elektronikkomponenten innerhalb des Gehäuses sind dabei mit elektrischem Strom zu versorgen. Aus diesem Grund ist es erforderlich, elektrische Kontakte durch eine Gehäusewandung des Gehäuses zu führen, um an einem äußeren Teil der Kontakteile den Sensor von außen mit elektrischem Strom versorgen zu können.

Bei einer fluiddichten Ausführung der Sensoren werden die Leiterplatte mit den Elektronikkomponenten und das Sensorelement in der Regel von einer Vergussmasse umhüllt. Die Vergussmasse dient dazu, einerseits die Leiterplatte und das Sensorelement form- und stoffschlüssig zu fixieren und andererseits schädigende Umwelteinflüsse, zum Beispiel Flüssigkeiten, von der Leiterplatte und dem Sensorelement fernzuhalten. Dadurch handelt es sich um einen fluiddichten Sensor. Vor dem Vergießen des Sensors mit der Vergussmasse ist es dabei erforderlich, die Leiterplatte und das Sensorelement mit dem Gehäuse mittelbar oder unmittelbar zur Positionierung der Leiterplatte und/oder des Sensorelements während des Vergießens des Gehäuseinnenraumes mit Vergussmasse zu verbinden. Vor dem Vergießen mit Vergussmasse wird dabei im Allgemeinen auch die Leiterplatte mit den elektrischen Kontakten des Sensors verbunden, im Allgemeinen mittels Löten. Bei einer Klebeverbindung zwischen der Leiterplatte und/oder dem Sensorelement sowie dem Gehäuse vor dem Vergießen mit Vergussmasse ist diese Klebeverbindung in der Herstellung aufwendig und teuer und weist eine geringe Flexibilität für unterschiedliche Arten von Sensoren auf.

Die DE 195 44 815 C1 zeigt einen Sensor mit einer auf einem Träger angeordneten elektrischen Schaltung, welche mit einem elektrischen Anschlusselement und mit einem Sensorelement verbunden ist. Ferner ist ein Gehäuse mit einem Innenraum zur Aufnahme des Trägers dargestellt, welches jeweils eine Öffnung für das Anschlusselement sowie für das Sensorelement aufweist. Dabei sind das Sensorelement und ein erster Teil des Trägers in eine Duroplast-Formmasse eingebettet. Ein zweiter Teil des Trägers und das elektrische Anschlusselement sind von einer Thermoplast-Formmasse umschlossen. In einem Zwischenraum, benachbart zu der Öffnung für das Sensorelement, zwischen der Duroplast-Formmasse und dem Gehäuse ist eine Dichtung angeordnet.

Die DE 100 13 218 C2 zeigt ein Verfahren zur Herstellung eines Positionssensors mit einem Gehäuse in dessen Gehäuseinnenraum ein auf einem Träger angeordneter elektrischer Schaltkreis sitzt, umfassend die Schritte: der Träger wird mit einem Steckereinsatz als elektrischem Anschlusselement zu einer Träger-Anschlusselement-Kombination verbunden, bei der das Anschlusselement starr mit dem Träger verbunden ist,
die Träger-Anschlusselement-Kombination wird in das an einem Messende geschlossene Gehäuse von einem dem Messende gegenüberliegenden Hinterende her eingeführt, der Raum um die Träger-Anschlusselement-Kombination im Gehäuseinnenraum wird bis zu einem bestimmten Niveau mit einer Formmasse verfüllt,
mit dem Hinterende des Gehäuses wird vor Aushärtung der Formmasse eine Kappe verbunden, durch die die Anschlüsse des Anschlusselements geführt sind, und
mit der die Träger-Anschlusselement-Kombination in dem Gehäuse fixiert wird.

Aus der Druckschrift DE 10 2008 040 156 A1 ist eine Vorfixierung einer Leiterplatte innerhalb eines Steuergerätes mittels einer eine kraft- und/oder formschlüssige Verbindung bekannt.
Die Druckschrift WO 2012 080 778 A1 zeigt eine Anordnung zum Halten von wenigstens zwei Sensoren in Verbindung mit einer Encoderscheibe. In einer gezeigten Ausführungsvariante werden fünf gleichartige Sensoren von einem Halteelement in Position gehalten. Das Halteelement weist fünf Aussparungen auf, in denen jeweils die Gehäuse der fünf Sensoren gehalten sind. Die Sensoren sind über Kontaktdrähte auf einer Leiterplatte befestigt. Das Halteelement, die Sensoren und die Leiterplatte bilden eine Baueinheit, welche in ein Gehäuse bringbar sind.
Die Aufgabe der vorliegenden Erfindung besteht darin, einen Sensor und ein Verfahren zur Herstellung eines Sensor zur Verfügung zu stellen, bei dem eine Leiterplatte und/oder ein Sensorelement mit einem geringen technischen Aufwand zuverlässig an dem Gehäuses vor dem Vergießen mit Vergussmasse befestigt werden können.
Diese Aufgabe wird gelöst mit einem Sensor gemäß den Merkmalen des Anspruchs 1 sowie mit einem Verfahren zur Herstellung des Sensors gemäß den Verfahrensschritten des Anspruchs 13.
Bei der Montage des Sensors kann somit zunächst die das Sensorelement einfach mittels einer kraftschlüssigen Verbindung, insbesondere einer Rast-, Klick- oder Pressverbindung, zunächst einfach und preiswert an dem Gehäuse fixiert werden. Anschließend erfolgt ein Vergießen des Gehäuseinnenraumes mit einer Vergussmasse, zum Beispiel einer thermoplastischen Formmasse oder einem Gießharz.

In einer zusätzlichen Ausführungsform ist die Leiterplatte kraftschlüssig mit dem Gehäuse verbunden. Dabei können die Leiterplatte und das Sensorelement ausschließlich kraftschlüssig mit dem Gehäuse verbunden sein, insbesondere abgesehen von der stoffschlüssigen Verbindung aufgrund der Vergussmasse und/oder abgesehen von einer mechanischen Verbindung zur, insbesondere ausschließlichen, elektrischen Verbindung der Leiterplatte und/oder des Sensorelementes.

Das Gehäuse ist vorzugsweise als ein Gehäusetopf und im Wesentlichen quaderförmig ausgebildet. Das Gehäuse besteht wenigstens teilweise, insbesondere vollständig, aus Metall und/oder Kunststoff. Das Gehäuse kann mehrteilig ausgeführt sein. Insbesondere kann das Gehäuse im Bereich des Sensorelementes als eine lichtdurchlässige oder lichtundurchlässige Kappe ausgebildet sein. Vorzugsweise sind die Kappe aus Kunststoff und das übrige Gehäuse aus Metall ausgebildet. Der Sensor ist ein induktiver Sensor. Zweckmäßig weist das Gehäuse zusätzlich auch einen Gehäusedeckel auf. Die Leiterplatte umfasst Leiterbahnen und die Elektronikkomponenten sind mit der Leiterplatte elektrisch und mechanisch verbunden. Vorzugsweise ist die Leiterplatte vollständig innerhalb des von dem des Gehäuse eingeschlossenen Gehäuseinnenraumes angeordnet. Die Leiterplatte und/oder das Sensorelement sind dabei von der Vergussmasse vollständig umschlossen sein. Dadurch kann an die Leiterplatte und/oder an das Sensorelement keine schädigenden Umwelteinflüsse, zum Beispiel eine Flüssigkeit, gelangen. Es handelt sich in diesem Fall um einen flüssigkeits- oder fluiddichten Sensor, der insbesondere spritzwassergeschützt ist.

In einer ergänzenden Variante ist an dem Gehäuse wenigstens eine Formschlussgeometrie und an der Leiterplatte wenigstens eine Gegenformschlussgeometrie ausgebildet, wobei die wenigstens eine Form- und Gegenformschlussgeometrie kraftschlüssig ineinander greifen zur Verbindung der Leiterplatte mit dem Gehäuse. Mittels der Formschlussgeometrie an dem Gehäuse und der Gegenformschlussgeometrie an der Leiterplatte kann vor dem Vergießen des Sensors mit Vergussmasse die Leiterplatte innerhalb des Gehäuses befestigt und positioniert werden. Die Formschlussgeometrie ist vorzugsweise als eine Verbindungsnocke und / oder ein Rastabsatz ausgebildet. Als Gegenformschlussgeometrie kann eine Öffnung und / oder eine Rastnase ausgebildet sein. Ein Kraftschluss erfolgt dabei vorzugsweise aufgrund einer Pressverbindung von Formschlussgeometrie und Gegenformschlussgeometrie.

In einer besonders vorteilhaften Ausführung des vorliegenden erfindungsgemässen Sensors ist an der wenigstens einen Gegenformschlussgeometrie je ein elektrisches Leiterplattenkontakt-element zur elektrisch leitenden Verbindung der Leiterplatte mit dem Gehäuse an der wenigstens einen Formschlussgeometrie ausgebildet. Damit kann zusätzlich zwischen der Leiterplatte und dem Gehäuse eine elektrisch leitende Verbindung zur Verfügung gestellt werden. Das je eine elektrische Leiterplattenkontaktelement kann hierbei als ein Metallring ausgeführt sein. Besteht das Gehäuse wenigstens teilweise, insbesondere vollständig, aus Metall, können dadurch in vorteilhafter Weise leitungsgebundene Hochfrequenzstörungen von der Leiterplatte zu dem Gehäuse geleitet werden. Besteht zusätzlich eine kraftschlüssige Verbindung zwischen der Formschlussgeometrie und Gegenformschlussgeometrie bzw. Leiterplattenkontaktelement, ist diese elektrische Verbindung zwischen der Leiterplatte und dem Gehäuse besonders zuverlässig ausgebildet, weil aufgrund der kraftschlüssigen Verbindung, zum Beispiel eine Pressverbindung, ständig ein mechanischer und dadurch auch ein elektrische Kontakt zwischen dem Leiterplattenkontaktelement an der Gegenformschlussgeometrie und der Formschlussgeometrie, zum Beispiel der Verbindungsnocke, besteht.

Das Sensorelement ist eine Spule und der Sensor ist ein induktiver Näherungssensor.

Das Sensorelement ist mittels eines elastischen Elementes zwischen dem Gehäuse und dem elastischen Element elastisch vorgespannt gehalten. Das elastische Element kann hierbei als eine Feder ausgeführt sein.

Das Sensorelement liegt an einem ersten Ende mittelbar oder unmittelbar auf dem Gehäuse, insbesondere der Kappe, auf und aufgrund der Geometrie des Gehäuses, beispielsweise als Ausnehmung, ist das Sensorelement formschlüssig an dem Gehäuse gehalten. Das elastische Element kann auch an einem zweiten Ende mittelbar oder unmittelbar auf dem Sensorelement aufliegen. Das erste und zweite Ende kann gegenüberliegend an dem Sensorelement ausgebildet sein. Das Sensorelement kann zwei Sensorelementkontaktelemente zur elektrischen Verbindung des Sensorelements umfassen. Die Sensorelementkontaktelemente können ferner stoffschlüssig, beispielsweise mit einer Lötverbindung, mit der Leiterplatte, insbesondere Leiterplattenkontaktelementen, elektrisch verbunden sein. An dem zweiten Ende ist das Sensorelement beispielsweise mittelbar mit einem Steckerteil kraftschlüssig unter elastischer Vorspannung mit dem elastischen Element verbunden. Eine elastische Vorspannung des elastischen Elements ist beispielsweise dadurch möglich, dass aufgrund einer kraftschlüssigen Verbindung, insbesondere einer Pressverbindung, zwischen der Form- und Gegenformschlussgeometrie Kräfte von dem elastischen Element auf die Leiterplatte und von der Leiterplatte auf das Gehäuse übertragen werden können.

In einer zusätzlichen Ausführungsform weist das Gehäuse eine Steckeröffnung auf, mit der eine Steckerhülse insbesondere kraftschlüssig, verbunden ist. Die kraftschlüssige Verbindung kann mittels einer Pressverbindung erfolgen. Innerhalb der Steckerhülse ist ein Steckerteil, beispielsweise aus Kunststoff, mit elektrischen Kontaktelementen als elektrische Kontakte angeordnet. Die Steckerhülse kann aus Metall ausgeführt sein. Ferner kann an der Steckeröffnung eine aus Kunststoff ausgeführte Kabeldichtung vorgesehen sein, durch die elektrische Stromkabel als elektrische Kontakte geführt sind.

Zweckmäßig umfasst der Sensor einen Lichtleiter und einen Lichtsender, beispielsweise eine LED, so dass von dem Lichtsender durch den Lichtleiter das von dem Lichtsender erzeugte Licht außerhalb des Sensors leitbar ist. Vorzugsweise ist der Lichtleiter außenseitig an zwei oder drei Seiten des Sensors angeordnet, so dass das von dem Lichtsender ausgestrahlte Licht an zwei oder drei Seiten des Sensors sichtbar ist.

Ein erfindungsgemäßes Verfahren zur Herstellung eines Sensors, insbesondere eines in dieser Schutzrechtsanmeldung beschriebenen Sensors, umfasst die nachfolgenden Schritte:
- zur Verfügung stellen eines Gehäuses,
- zur Verfügung stellen einer Leiterplatte mit Elektronikkomponenten,
- zur Verfügung stellen eines Sensorelementes,
- Einführen des Sensorelementes in einen von dem Gehäuse eingeschlossenen Gehäuseinnenraum wobei das Sensorelement an einem ersten Ende mittelbar oder unmittelbar auf dem Gehäuse, insbesondere einer Kappe, aufliegt und aufgrund der Geometrie des Gehäuses, vorzugsweise als Ausnehmung, das Sensorelement formschlüssig an dem Gehäuse gehalten ist,
- Einführen der Leiterplatte in einen von dem Gehäuse eingeschlossenen Gehäuseinnenraum, wobei eine an dem Gehäuse ausgebildete Formschlussgeometrie und eine an der Leiterplatte ausgebildete Gegenformschlussgeometrie kraftschlüssig ineinander greifen zur Verbindung der Leiterplatte mit dem Gehäuse, wobei das Sensorelement mittels eines elastischen Elementes zwischen dem Gehäuse und dem elastischen Element elastisch vorgespannt gehalten ist.

Dadurch ist in vorteilhafter Weise beispielsweise keine aufwendige Klebeverbindung zwischen der Leiterplatte und/oder dem Sensorelement vor dem Vergießen mit einer Vergussmasse erforderlich.

Insbesondere wird dabei eine kraftschlüssige Verbindung, welche dazu dient, die Leiterplatte und/oder das Sensorelement elektrisch zu verbinden, beispielsweise mit den Kontakten zur elektrischen Versorgung des Sensors, nicht in Betracht gezogen. Derartige mechanische Verbindung zur elektrischen Verbindung stellen zwar auch mechanische Verbindungen dar, können jedoch aufgrund ihrer mechanischen Eigenschaften keinen oder im Wesentlichen keinen Beitrag für eine ausreichende mechanische Befestigung bzw. Positionierung der Leiterplatte und/oder des Sensorelements vor einem Vergießen mit der Vergussmasse zur Verfügung stellen.

Das Gehäuse kann mittels Spritzgießen, z. B. aus Kunststoff, insbesondere thermoplastischen Kunststoff, oder aus Metall, z. B. Zink oder einer Zinklegierung, zur Verfügung gestellt und vorzugsweise wird das Gehäuse nach dem Spritzgießen beschichtet, insbesondere mittels Galvanisieren, z. B. mit Metall, insbesondere Nickel.

Zweckmäßig wird das Gehäuse als ein Gehäusetopf zur Verfügung gestellt und/oder das Gehäuse wird mit einer Kappenöffnung zur Verfügung gestellt und/oder das Gehäuse wird mit einer Steckeröffnung zur Verfügung gestellt, insbesondere wird an der Steckeröffnung wenigstens ein Pressabsatz, vorzugsweise zwei Pressabsätze, ausgebildet.

Die Kappenöffnung kann mit einer Kappe verschlossen werden, insbesondere die Kappe form- und/oder kraftschlüssig, beispielsweise mit einer Rastverbindung, mit dem Gehäuse verbunden wird, insbesondere vor dem Vergießen mit Vergussmasse.

In die Steckeröffnung kann ferner eine Steckerhülse eingeführt werden, wobei die Steckerhülse mit dem Gehäuse an der Steckeröffnung mit einer form- und/oder kraftschlüssigen Verbindung, insbesondere einer Pressverbindung, verbunden wird, so dass insbesondere wenigstens ein Gegenpressabsatz, vorzugsweise wenigstens zwei Gegenpressabsätze, an der Steckerhülse auf dem wenigstens einen Pressabsatz, vorzugsweise zwei Pressabsätzen, an der Steckeröffnung des Gehäuses aufliegen, insbesondere vor dem Vergießen mit Vergussmasse.

In die Steckeröffnung kann eine Kabeldichtung eingeführt werden und form- und/oder kraft- und/oder stoffschlüssig mit dem Gehäuse an der Steckeröffnung verbunden werden, insbesondere vor dem Vergießen mit Vergussmasse. Aufgrund des Pressabsatzes an dem Gehäuse und des Gegenpressabsatzes an der Steckerhülse, vorzugsweise aus Metall, kann dadurch eine ausreichende Pressverbindung zur Verfügung gestellt und hergestellt werden bei einer geringen Gehäusewanddicke an der Steckeröffnung. Der Pressabsatz und der Gegenpressabsatz stellt damit eine zusätzliche Pressfläche in Ergänzung zu der normalen Pressöffnung an der Steckeröffnung der entsprechenden Gehäusewandung, beispielsweise Rückwandung, des Gehäuses zur Verfügung.

In einer weiteren Variante wird in die Steckerhülse ein Steckerteil, z. B. aus Kunststoff, mit den elektrische Kontaktelementen als Kontakte eingeführt und mit der Steckerhülse form-und/oder kraft- und/oder stoffschlüssig verbunden, insbesondere nach dem Verbinden der Steckerhülse mit dem Gehäuse an der Steckeröffnung, insbesondere vor dem Vergießen mit Vergussmasse. Durch eine Kabelöffnung können hierbei Stromkabel geführt werden, insbesondere nach dem Verbinden der Kabeldichtung mit dem Gehäuse an der Steckeröffnung, insbesondere vor dem Vergießen mit Vergussmasse.

In einer zusätzlichen Ausführungsform wird das Sensorelement mit dem Gehäuse verbunden, indem das Sensorelement zwischen dem Gehäuse, insbesondere der Kappe, und einem elastischen Element, insbesondere einer Feder, elastisch vorgespannt gehalten wird, insbesondere vor dem Vergießen mit Vergussmasse, und/oder die Leiterplatte wird auf wenigstens einen Gehäuseabsatz, insbesondere wenigstens zwei Gehäuseabsätze, aufgelegt, insbesondere vor dem Vergießen mit Vergussmasse, und/oder die Leiterplatte wird mit wenigstens einer Formschlussgeometrie an wenigstens einer Gegenformschlussgeometrie an dem Gehäuse formschlüssig verbunden, insbesondere wenigstens eine Verbindungsnocke, vorzugsweise zwei Verbindungsnocken, an dem Gehäuse in wenigstens eine Öffnung, insbesondere zwei Öffnungen, an der Leiterplatte eingeführt werden, insbesondere vor dem Vergießen mit Vergussmasse.

In einer ergänzenden Variante wird die wenigstens eine Formschlussgeometrie an der Leiterplatte zusätzlich kraftschlüssig mit der wenigstens einen Gegenformschlussgeometrie an der Leiterplatte verbunden, insbesondere indem wenigstens eine Verbindungsnocke an dem Gehäuse mit der Leiterplatte an der Öffnung verpresst wird, insbesondere vor dem Vergießen mit Vergussmasse, und/oder das elastische Element wird stoffschlüssig, beispielsweise mittels Löten, mit der Leiterplatte verbunden und/oder Sensorelementkontaktelemente an dem Sensorelement werden elektrisch mit der Leiterplatte verbunden, insbesondere indem die Sensorelementkontaktelemente mit Leiterplattenkontaktelementen verlötet werden, insbesondere vor dem Vergießen mit Vergussmasse, und/oder die elektrischen Kontakte werden elektrisch mit der Leiterplatte verbunden, insbesondere indem die Kontakte mit Leiterplattenkontaktelementen verlötet werden, insbesondere vor dem Vergießen mit Vergussmasse.

In einer zusätzlichen Ausgestaltung wird ein Lichtleiter, insbesondere vor dem Vergießen mit Vergussmasse, mit dem Gehäuse kraftschlüssig, beispielsweise mit einer Rastverbindung, verbunden, insbesondere vor dem Vergießen mit Vergussmasse.

Zweckmäßig umfasst der Gehäusetopf nur eine Öffnung zum Einführen der Leiterplatte.

In einer weiteren Ausführungsform ist der Sensor fluiddicht, insbesondere sind die Leiterplatte mit Elektronikkomponenten und/oder das Sensorelement fluiddicht von der Vergussmasse eingehüllt bzw. eingebettet.

Im Nachfolgenden wird ein Ausführungsbeispiel der Erfindung unter Bezugnahme auf die beigefügten Zeichnungen näher beschrieben. Es zeigt:
- Fig. 1: eine Draufsicht eines Gehäuses des Sensors,
- Fig. 2: eine Seitenansicht des Gehäuses gemäß Fig. 1,
- Fig. 3: einen Längsschnitt B-B des Gehäuses gemäß Fig. 1,
- Fig. 4: einen Querschnitt A-A des Gehäuses gemäß Fig. 1,
- Fig. 5: eine Draufsicht einer Leiterplatte des Sensors,
- Fig. 6: eine Rückansicht der Leiterplatte gemäß Fig. 5,
- Fig. 7: einen Längsschnitt des Sensors und
- Fig. 8: eine perspektivische Ansicht des Sensors gemäß Fig. 7.

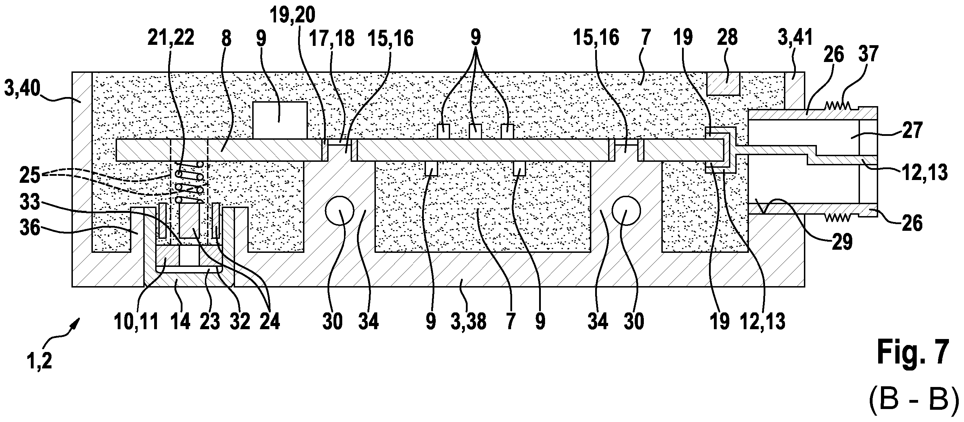

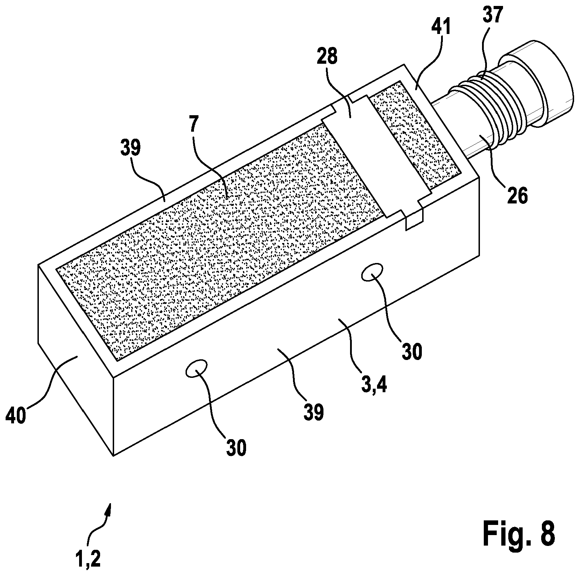

Ein in Fig. 7 und 8 dargestellter Sensor 1 ist als ein induktiver Sensor 2 ausgebildet und stellt damit einen Näherungssensor dar. Mit dem induktiven Sensor 2 können Gegenstände im Bereich oder in dessen Nähe erfasst werden.

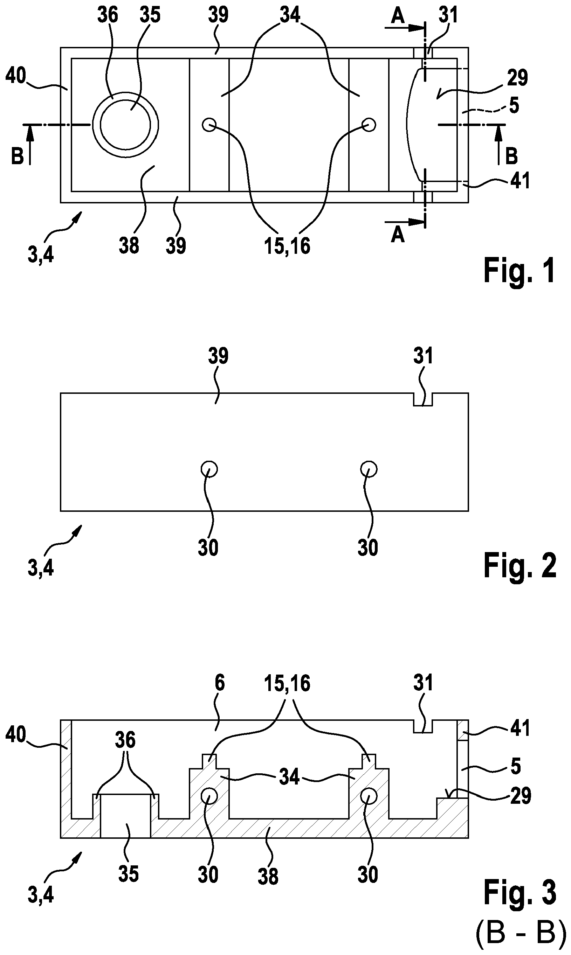

Der Sensor 1,2 umfasst ein Gehäuse 3, welches als Gehäusetopf 4 ausgebildet ist (dargestellt in Fig.3). Das Gehäuse 3 besteht aus Metall, nämlich einer Zinklegierung, und ist mittels eines Zinkdruckgussverfahrens hergestellt. Der Gehäusetopf 4 (Fig. 1 bis 4) schließt einen Gehäuseinnenraum 6 ein. Der Gehäuseinnenraum 6 ist dabei von einer Bodenwandung 38, zwei Seitenwandungen 39, einer Vorderwandung 40 und einer Rückwandung 41 des Gehäusetopfes 4 begrenzt. An der Bodenwandung 38 sind in Querrichtung zwei Gehäuseabsätze 34 ausgebildet. Oberseitig an den Gehäuseabsätzen 34 ist jeweils zur Auflage einer Leiterplatte 8 eine Verbindungsnocke 16 als Formschlussgeometrie 15 ausgebildet. In die beiden Absätze 34 ist jeweils in Querrichtung eine Befestigungsbohrung 30 vorhanden. Die Befestigungsbohrungen 30 weisen vorzugsweise ein Gewinde auf.

Die Bodenwandung 38 weist ferner eine Kappenöffnung 35 auf. An der Kappenöffnung 35 weist das Gehäuse 3 einen Kappenring 36 auf. Eine Steckeröffnung 5 an der Rückwandung 41 dient zur Einführung einer Steckerhülse 26. Dabei ist an dem Gehäuse 3 im Bereich der Steckeröffnung 5 untenseitig ein Pressabsatz 29 ausgebildet. Der Pressabsatz 29 dient dazu, eine zusätzliche Pressfläche zwischen dem Gehäuse 3 und der Steckerhülse 26 bei einer Herstellung und Verbindung der Steckerhülse 26 mit dem Gehäuse 3 an der Steckeröffnung 5 herzustellen.

Die beiden Seitenwandungen 39 weisen obenseitig zwei Gehäuseaussparungen 31 für einen Lichtleiter 28 auf.

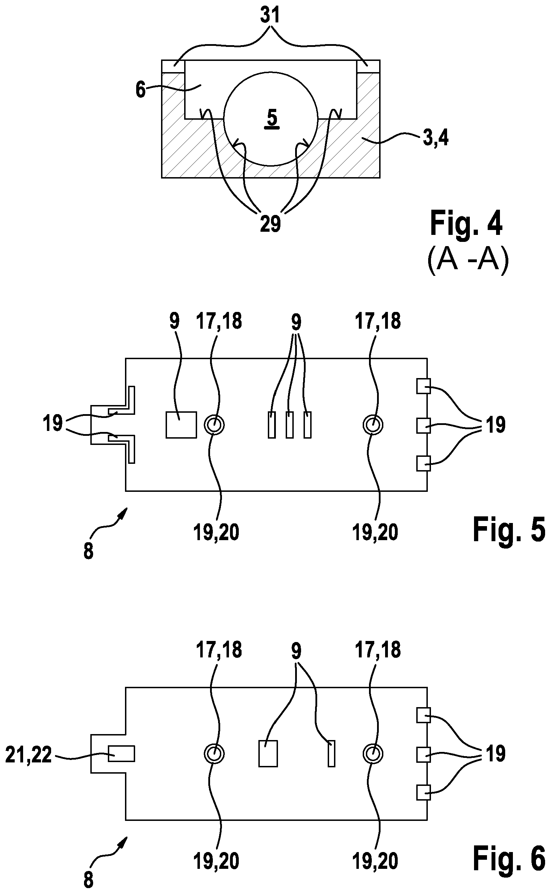

An der Leiterplatte 8 (Fig. 5 und 6) sind oberseitig vier Elektronikkomponenten 9, zum Beispiel ein Controller und ein elektrischer Widerstand, mechanisch und elektrisch mit der Leiterplatte 8 verbunden. Die Leiterplatte 8 weist hierzu nicht dargestellte Leiterbahnen auf. An der Unterseite der Leiterplatte 8 (Fig. 6) sind zwei Elektronikkomponenten 9 mit der Leiterplatte 8 mechanisch und elektrisch verbunden. Die Leiterplatte 8 aus Kunststoff weist zwei Öffnungen 18 auf, die eine Gegenformschlussgeometrie 17 bilden. Dabei sind an diesen Öffnungen 18 der Leiterplatte 8 zusätzlich Metallringe 20 als Leiterplattenkontaktelemente 19 angeordnet. Die Metallringe 20 sind elektrisch leitend mit den jeweiligen Verbindungsnocken 16 verbunden. Damit können in vorteilhafter Weise Störspannungen über das Gehäuse 3 abgeleitet werden.

Ferner ist an der Unterseite der Leiterplatte 8 eine Feder 22 als elastisches Element 21 befestigt. Die Befestigung ist in dieser Ausführung mittels einer Lötverbindung realisiert.

Die Leiterplatte 8 weist ferner an der Oberseite, gemäß der Darstellung in Figur 5 rechts, drei Leiterplattenkontaktelemente 19 auf. Die drei Leiterplattenkontaktelemente 19 sind im Querschnitt U-förmig (Fig. 7) ausgebildet und dadurch auch an der Unterseite vorhanden und somit auch in Fig. 6 sichtbar.

Durch das zur Herstellung des Gehäusetopfes 4 angewendete Zinkdruckgussverfahrens kann die oben beschriebene Geometrie des Gehäusetopfes 4, zum Beispiel mit den Gehäuseabsätzen 34 und der Kappenöffnung 35 mit dem Kappenring 36, bereits einfach beim Druckgussverfahren mit hergestellt werden, ohne dass anschließend eine Nachbearbeitung, zum Beispiel spanabhebend, erforderlich ist.

Anschließend wird in die Kappenöffnung 35 an der Bodenwandung 38 des Gehäuses 3 eine Kappe 14 aus Kunststoff eingeschoben und eingedrückt, sodass ein form- und/oder kraftschlüssige Verbindung zwischen der Kappe 14 und dem Kappenring 36 an dem Gehäuse 3 hergestellt wird. Der Kappenring 36 stellt dabei eine relativ große Verbindungsfläche zwischen der Kappe 14 und dem Gehäuse 3, das heißt dem Kappenring 36, zur Verfügung. Anschließend wird die Steckerhülse 26 aus Metall in die Steckeröffnung 5 an der Rückwandung 41 eingeschoben und eingepresst, sodass eine Pressverbindung zwischen der Steckerhülse 26 und dem Gehäuse 3 hergestellt wird. Aufgrund des Pressabsatzes 29 an dem Gehäuse 3 und einem Gegenpressabsatz an der Steckerhülse 26 steht eine große Pressverbindungsfläche zwischen der Steckerhülse 26 und dem Gehäuse 3 zur Verfügung. Dadurch weißt die Dicke der Rückwandung 41 die gleiche Dicke auf, wie die übrigen Wandungen des Gehäuses 3. Nach der Herstellung der Pressverbindung zwischen der Steckerhülse 26 und dem Gehäuse 3 wird in die Steckerhülse 26 ein Steckerteil 27 aus Kunststoff eingeschoben. Das Steckerteil 27 ist aus thermoplastischem Kunststoff mittels Spritzgießen hergestellt. Dabei sind drei elektrische Kontaktelemente 13 als elektrische Kontakte 12 von dem Kunststoff des Steckerteils 27 umspritzt.

Die elektrischen Kontaktelemente 13 dienen dazu, den Sensor 1 elektrisch mit der Umgebung zu verbinden. Dabei sind in das Steckerteil 27 drei elektrische Kontaktelemente 13 integriert, von denen jedoch aufgrund der Schnittbildung in Fig. 7 nur ein elektrisches Kontaktelement 13 dargestellt ist. Die elektrischen Kontaktelemente 13 sind an dem in Fig. 7 dargestellten rechten Ende außerhalb des Sensors 1 angeordnet und können dadurch mit entsprechenden elektrischen Kontaktgegenelementen (nicht dargestellt) mechanisch und elektrisch verbunden werden. Hierzu ist ein entsprechender elektrischer Gegensteckverbinder (nicht dargestellt) auf ein Außengewinde 37 der Steckerhülse 26 aufzuschrauben. Dadurch können die elektrischen Kontaktgegenelemente mit den elektrischen Kontaktelementen 13 verbunden werden.

Das Steckerteil 27 wird dabei form- und/oder kraftschlüssig, zum Beispiel mittels einer Rastverbindung, mit der Steckerhülse 26 verbunden.

Anschließend wird eine Spule 11 als Sensorelement 10 für den induktiven Sensor 2 auf die Kappe 14 aufgelegt.

In weiteren Ausführungen insbesondere bei optischen Sensoren (hier nicht beschrieben) kann das Sensorelement 10 als eine LED und / oder ein Fototransistor ausgebildet sein.

Die Kappe 14 weist dabei eine entsprechende Geometrie auf, sodass sich an der Kappe 14 innenseitig eine Ausnehmung 23 ausbildet, die komplementär zur Geometrie der Spule 11 ausgebildet ist. Damit ist in der Ausnehmung 23 der Kappe 14 die Spule 11 formschlüssig gehalten.

Darauffolgend wird die Leiterplatte 8 auf das Gehäuse 3 aufgelegt, indem zunächst die beiden Verbindungsnocken 16 in die beiden Öffnungen 18 der Leiterplatte 8 eingeführt und anschließend die Leiterplatte 8 auf den beiden Gehäuseabsätzen 34 aufgelegt wird. Dadurch besteht eine formschlüssige Verbindung zwischen der Leiterplatte 8 und dem Gehäuse 3 an den Verbindungsnocken 16 sowie den Gehäuseabsätzen 34. Zusätzlich wird noch mittels eines entsprechenden Werkzeugs eine Pressverbindung zwischen den Verbindungsnocken 16 und der Öffnung 18 an der Leiterplatte 8 hergestellt. Die Öffnungen 18 weisen jeweils Metallringe 20 an der Leiterplatte 8 auf. Dadurch kommt es zu einer kraftschlüssigen Verbindung zwischen dem Gehäuse 3 und der Leiterplatte 8.

Die Spule 11 wird auf die Kappe 14 gebracht. Ein Zwischenteil 24 wiederum ist zum Aufsetzen auf ein zweites Ende 33, dem oberen Ende der Spule 11, gemäß der Darstellung in Fig. 7, vorgesehen. Das Zwischenteil 24 ist aus Kunststoff ausgeführt.

Beim Auflegen der Leiterplatte 8 auf das Gehäuse 3 wird dadurch die Feder 22 auf das Zwischenteil 24 aufgelegt und die Feder 22 elastisch vorgespannt, sodass mittels des Zwischenteils 24 die Spule 11 mittelbar mit der Feder 22 elastisch vorgespannt an der Leiterplatte 8 befestigt ist. Ein erstes Ende 32 der Spule 11 liegt dabei auf der Kappe 14 auf. Das erste Ende 32 stellt gemäß der Darstellung in Fig. 7 ein unteres Ende der Spule 11 dar. Die Spule 11 ist damit unter Vorspannung zwischen der Leiterplatte 8 und der Kappe 14 befestigt. Dadurch sind sowohl die Leiterplatte 8 als auch die Spule 11 vor dem Vergießen mit einer Vergussmasse 7 bezüglich des Gehäuses 3 positioniert und daran befestigt.

Zur elektrischen Verbindung der Spule 11 mit der Leiterplatte 8 weist die Spule 11 zwei Kontaktelemente 25 zur Verbindung der Spule 11 auf, die in Fig. 7 strichliert dargestellt sind. Diese zwei Kontaktelemente 25 zur Verbindung der Spule 11 werden anschließend mit den beiden in Fig. 5 links dargestellten Leiterplattenkontaktelementen 19 verlötet, sodass dadurch die Spule 11 elektrisch und geringfügig mechanisch mit der Leiterplatte 8 bzw. den Leiterplattenkontaktelementen 19 verbunden ist.

Zusätzlich werden auch die drei elektrischen Kontaktelemente 13 an dem Steckerteil 27, deren linkes inneres Ende in dem von dem Gehäuse 3 eingeschlossenen Gehäuseinnenraum 6 enden, mit den drei in Fig. 5 und 6 rechts dargestellten Leiterplattenkontaktelementen 19 verlötet, sodass dadurch die Leiterplatte 8 elektrisch mit den drei elektrischen Kontaktelementen 13 verbunden ist und damit auch der Sensor 1 bezüglich der elektrischen Verbindung nach außen hergestellt ist.

Vor dem Vergießen mit der Vergussmasse 7 wird ferner ein Lichtleiter 28 aus einem lichtleitenden Kunststoff mit den beiden Gehäuseaussparungen 31 an den beiden Seitenwandungen 39 oberseitig verbunden, zum Beispiel mittels einer Clips- oder Rastverbindung.

Anschließend wird der Gehäuseinnenraum 6 mit der Vergussmasse 7 ausgegossen, sodass dadurch die Leiterplatte 8 und die Spule 11 vollständig von der Vergussmasse 7 umschlossen sind. Dadurch stellt der Sensor 1 einen fluiddichten Sensor 1 dar.

In einem weiteren, nicht dargestellten Ausführungsbeispiel ist in der Steckeröffnung 5 anstelle der Steckerhülse 26 und dem Steckerteil 27 eine Kabeldichtung angeordnet. Die Kabeldichtung ist dabei als ein Stutzen mit einer Kabelöffnung ausgebildet und durch diese Kabelöffnung können drei Stromkabel als elektrische Kontakte 12 geführt werden. Diese Stromkabel sind dabei an einem Ende mit den drei in Fig. 5 und 6 rechts dargestellten Leiterplattenkontaktelementen 19 verlötet. An den rechten Enden der Stromkabel können diese beispielsweise mittels einer elektrischen Schraubverbindung mit einer entsprechenden Einheit außerhalb des Sensors 1 verbunden werden.

Der Zwischenraum bzw. Freiraum zwischen der Kabelöffnung und den Stromkabeln wird dabei während des Ausgießens mit der Vergussmasse 7 abgedichtet und verschlossen.

Die Fließfähigkeit bzw. Zähigkeit der Vergussmasse 7 vor dem Erhärten ist dabei dahingehend ausgelegt, dass kein oder im Wesentlichen keine Vergussmasse 7 aus diesen Restöffnungen durch die Kabelöffnung gelangt.

Insgesamt betrachtet sind mit dem erfindungsgemäßen Sensor 1 und dem erfindungsgemäßen Verfahren zur Herstellung des Sensors 1 wesentliche Vorteile verbunden.

Die Leiterplatte 8 und die Spule 11 werden vor dem Vergießen mit der Vergussmasse 7 form- und kraftschlüssig mittelbar oder unmittelbar mit dem Gehäuse 3 verbunden. Dadurch können die Leiterplatte 8 und die Spule 11 einfach und kostengünstig vor dem Vergießen mit der Vergussmasse 7 an dem Gehäuse 3 gehalten und damit im Gehäuseinnenraum 6 positioniert werden. Aufwendige Klebeverbindungen vor dem Vergießen mit der Vergussmasse 7 zwischen der Leiterplatte 8 und/oder der Spule 11 sind dadurch nicht erforderlich. Außerdem können dadurch in vorteilhafter Weise unterschiedliche Sensoren 1 mit dem gleichen Herstellungsverfahren flexibel hergestellt werden.

## Patentansprüche

1. Induktiver Näherungssensor (1), umfassend wenigstens
- ein Gehäuse (3), welches einen Gehäuseinnenraum (6) einschließt,
- eine Leiterplatte (8) mit Elektronikkomponenten (9), welche innerhalb des Gehäuseinnenraumes (6) angeordnet ist,
- ein Sensorelement (10), welches mit der Leiterplatte (8) elektrisch verbunden ist und innerhalb des Gehäuseinnenraumes (6) angeordnet ist, wobei das Sensorelement (10) eine Spule (11) ist und
- die Leiterplatte (8) und / oder das Sensorelement (10) von einer Vergussmasse vollständig umschlossen sind,
**dadurch gekennzeichnet, dass**
die Spule (11) mittels eines elastischen Elementes (21) zwischen dem Gehäuse (3) und dem elastischen Element (21) elastisch vorgespannt gehalten ist, wobei das elastische Element (21) derart in dem Gehäuse (3) angeordnet ist, dass es auf einer Seite die Spule (11) an das Gehäuse (3, 14) drückt und auf der anderen Seite an der Leiterplatte (8) abgestützt gehalten oder befestigt ist, so dass die Spule (11) kraftschlüssig mit dem Gehäuse (3) verbunden ist und im Gehäuseinnenraum (6) in Position gehalten ist.

2. Induktiver Näherungssensor nach Anspruch 1, **dadurch gekennzeichnet, dass** das elastischen Element (21) als eine Feder (22) ausgebildet ist.

3. Induktiver Näherungssensor nach einem der vorhergehenden Ansprüche, **dadurch gekennzeichnet, dass** das elastische Element (21) mit der Leiterplatte (8), vorzugsweise mit einer Lötverbindung verbunden und gehalten ist.

4. Induktiver Näherungssensor nach einem der vorhergehenden Ansprüche, **dadurch gekennzeichnet, dass** das elastische Element (21) elektrische leitend ausgeführt ist und ausgebildet ist, eine elektrische Verbindung der Spule (11) mit der Leiterplatte (8) herzustellen.

5. Induktiver Näherungssensor nach einem der vorhergehenden Ansprüche, **dadurch gekennzeichnet, dass** die Spule (11) an einem ersten Ende (32) mittelbar oder unmittelbar auf dem Gehäuse (3), insbesondere einer Kappe (14), aufliegt und aufgrund der Geometrie des Gehäuses (3), vorzugsweise als Ausnehmung (23), die Spule (11) formschlüssig an dem Gehäuse (3) gehalten ist, wobei das elastische Element (21) an einem zweiten Ende (33) mittelbar oder unmittelbar auf der Spule (11) aufliegt, wobei das erste und zweiten Ende (32, 33) gegenüberliegend an der Spule (11) ausgebildet sind, wobei die Spule (11) vorzugsweise zwei Kontaktelemente (25) zur elektrischen Verbindung der Spule (11) umfasst und die Kontaktelemente (25) stoffschlüssig, beispielsweise mit einer Lötverbindung, mit der Leiterplatte (8), insbesondere den Leiterplattenkontaktelementen (19), elektrisch verbunden sind.

6. Induktiver Näherungssensor nach einem der vorhergehenden Ansprüche, **dadurch gekennzeichnet, dass** die Leiterplatte (8) kraftschlüssig mit dem Gehäuse (3) verbunden ist.

7. Induktiver Näherungssensor nach Anspruch 6, **dadurch gekennzeichnet, dass** an dem Gehäuse (3) wenigstens eine Formschlussgeometrie (15) und an der Leiterplatte (8) wenigstens eine Gegenformschlussgeometrie (17) ausgebildet sind und die wenigstens eine Form- und Gegenformschlussgeometrie (15, 17) kraftschlüssig ineinander greifen zur Verbindung der Leiterplatte (8) mit dem Gehäuse (3).

8. Induktiver Näherungssensor nach Anspruch 7, **dadurch gekennzeichnet, dass** als Formschlussgeometrie (15) eine Verbindungsnocke (16) und/oder ein Rastabsatz ausgebildet ist.

9. Induktiver Näherungssensor nach Anspruch 7, **dadurch gekennzeichnet, dass** als Gegenformschlussgeometrie (17) eine Öffnung (18) und/oder eine Rastnase ausgebildet ist.

10. Induktiver Näherungssensor nach Anspruch 7, **dadurch gekennzeichnet, dass** ein Kraftschluss aufgrund einer Pressverbindung von Formschlussgeometrie (15) und Gegenformschlussgeometrie (17) erfolgt.

11. Induktiver Näherungssensor nach Anspruch 10, **dadurch gekennzeichnet, dass** an der wenigstens einen Gegenformschlussgeometrie (17) je ein elektrisches Leiterplattenkontaktelement (19), vorzugsweise ein Metallring (20), zur elektrisch leitenden Verbindung der Leiterplatte (8) mit dem Gehäuse (3) an der wenigstens einen Formschlussgeometrie (15), ausgebildet ist.

12. Induktiver Näherungssensor nach einem oder mehreren der vorhergehenden Ansprüche, **dadurch gekennzeichnet, dass** der Sensor (1) einen Lichtleiter (28) und einen Lichtsender, beispielsweise eine LED, umfasst, so dass von dem Lichtsender durch den Lichtleiter (28) das von dem Lichtsender erzeugte Licht außerhalb des Sensors (1) leitbar ist und vorzugsweise der Lichtleiter (28) außenseitig an zwei oder drei Seiten des Sensors (1) angeordnet ist, so dass das von dem Lichtsender ausgestrahlte Licht an zwei oder drei Seiten des Sensors (1) sichtbar ist.

13. Verfahren zur Herstellung eines induktiven Näherungssensors (1) gemäss einem oder mehreren der vorhergehenden Ansprüche, mit wenigstens den Schritten:
- zur Verfügung stellen eines Gehäuses (3),
- zur Verfügung stellen einer Leiterplatte (8) mit Elektronikkomponenten (9),
- zur Verfügung stellen eines Sensorelementes (10), wobei das Sensorelement eine Spule (11) ist,
- Einführen der Spule (11) in einen von dem Gehäuse (3) eingeschlossenen Gehäuseinnenraum (6), wobei die Spule (11) an einem ersten Ende (32) mittelbar oder unmittelbar auf dem Gehäuse (3), insbesondere einer Kappe (14), aufliegt und aufgrund der Geometrie des Gehäuses (3), vorzugsweise als Ausnehmung (23), die Spule (11) formschlüssig an dem Gehäuse (3) gehalten ist,
- Einführen der Leiterplatte (8) in einen von dem Gehäuse (3) eingeschlossenen Gehäuseinnenraum (6), wobei eine an dem Gehäuse (3) ausgebildete Formschlussgeometrie (15) und eine an der Leiterplatte (8) ausgebildete Gegenformschlussgeometrie (17) kraftschlüssig ineinander greifen zur Verbindung der Leiterplatte (8) mit dem Gehäuse (3),
- Einbringen eines elastisches Elementes (21) in einen von dem Gehäuse (3) eingeschlossenen Gehäuseinnenraum (6), wobei das elastische Element (21) auf einer Seite die Spule (11) an das Gehäuse (3, 14) drückt und auf der anderen Seite an der Leiterplatte (8) abgestützt gehalten oder befestigt ist, so dass die Spule (11) mittels des elastischen Elementes (21) zwischen dem Gehäuse (3) und dem elastischen Element (21) elastisch vorgespannt gehalten ist
- Vergiessen des eingeschlossenen Gehäuseinnenraumes (6) mit einer Vergussmasse, insbesondere mit einer thermoplastischen Vergussmasse oder einem Giessharz.

14. Verfahren nach Anspruch 13, **dadurch gekennzeichnet, dass** das elastische Element (21) in einem Bestückungsprozess der Leiterplatte (8) auf die Leiterplatte(8) gelötet wird.

15. Verfahren nach Anspruch 14, **dadurch gekennzeichnet, dass** die Leiterplatte (8) auf wenigstens einen Gehäuseabsatz (34), insbesondere wenigstens zwei Gehäuseabsätze (34), aufgelegt wird, insbesondere vor einem Vergiessen mit einer Vergussmasse (7).

## Claims

1. Inductive proximity sensor (1), comprising at least
- one housing (3) which encloses a housing interior (6),
- a printed circuit board (8) with electronic components (9) which is located within the housing interior (6),
- a sensing element (10) which is electrically connected to the printed circuit board (8) and is located within the housing interior (6), whereby the sensor element (10) is a coil (11) and
- the printed circuit board (8) and/or the sensing element (10) are completely enclosed by a sealing compound,
**characterized in that**
the coil (11) is held in position under elastic pre-tension by means of an elastic element (21) between the housing (3) and the elastic element (21), whereby the elastic element (21) is located in the housing (3) in such a way that on one side it presses the coil (11) against the housing (3, 14), and on the other side is supported by or attached to the printed circuit board (8) in such a way that the coil (11) is frictionally connected to the housing (3) and is held in position in the housing interior (6).

2. Inductive proximity sensor in accordance with Claim 1, **characterized in that** the elastic element (21) is designed as a spring (22).

3. Inductive proximity sensor in accordance with any one of the preceding Claims, **characterized in that** the elastic element (21) is connected to and held by the printed circuit board (8), preferably by means of a soldered connection.

4. Inductive proximity sensor in accordance with any one of the preceding Claims, **characterized in that** the elastic element (21) is electrically conductive and is formed to establish an electrical connection between the coil (11) and the printed circuit board (8).

5. Inductive proximity sensor in accordance with any one of the preceding claims, **characterized in that** at a first end (32) the coil (11) rests indirectly or directly on the housing (3), in particular on a cap (14), and on account of the geometry of the housing (3), preferably as a recess (23), the coil (11) is held by means of a positive connection on the housing (3), whereby at a second end (33) the elastic element (21) rests indirectly or directly on the coil (11), whereby the first and second ends (32, 33) are located opposite each other on the coil (11),
whereby the coil (11) preferably comprises two contact elements (25) for the electrical connection of the coil (11), and the contact elements (25) are interfacially electrically connected to the printed circuit board (8), in particular to the printed circuit board contact elements (19), for example by means of a soldered connection.

6. Inductive proximity switch in accordance with any one of the preceding claims, **characterized in that** the printed circuit board (8) is frictionally connected to the housing (3).

7. Inductive proximity sensor in accordance with Claim 6, **characterized in that** at least one positive connection geometry (15) is formed on the housing (3) and at least one counter-positive connection geometry (17) is formed on the printed circuit board (8), and the at least one positive and counter-positive geometries (15, 17) engage frictionally with each other to connect the printed circuit board (8) to the housing (3).

8. Inductive proximity sensor in accordance with Claim 7, **characterized in that** a connecting cam (16) and/or a locking projection is formed as a positive connection geometry (15).

9. Inductive proximity sensor in accordance with Claim 7, **characterized in that** an opening (18) and/or a locking catch is formed as a counter-positive connection geometry (17).

10. Inductive proximity sensor in accordance with Claim 7, **characterized in that** a frictional connection is effected on the basis of a press connection between the positive connection geometry (15) and the counter-positive connection geometry (17).

11. Inductive proximity sensor in accordance with Claim 10, **characterized in that** on each of the at least one counter-positive connection geometries (17) an electrical printed circuit board contact element (19), preferably a metal ring (20), is formed on the at least one positive connection geometry (15) to establish an electrically conductive connection between the printed circuit board (8) and the housing (3).

12. Inductive proximity sensor in accordance with one or more of the preceding Claims, **characterized in that** the sensor (1) comprises an optical fiber (28) and a light transmitter, for example an LED, so that the light produced by the light transmitter can be conducted outside the sensor (1) from the light transmitter through the optical fiber (28), and the optical fiber (28) is preferably located on the outside on two or three sides of the sensor (1), so that the light radiated by the light transmitter is visible on two or three sides of the sensor (1).

13. Process for producing an inductive proximity sensor (1) in accordance with one or more of the preceding Claims, with at least the following steps:
- provision of a housing (3),
- provision of a printed circuit board (8) with electronic components (9),
- provision of a sensing element (10), whereby the sensing element is a coil (11),
- insertion of the coil (11) in a housing interior (6) enclosed by the housing (3), whereby at a first end (32) the coil (11) rests indirectly or directly on the housing (3), in particular on a cap (14), and on account of the geometry of the housing (3), preferably as a recess (23), the coil (11) is held by means of a positive connection on the housing (3),
- insertion of the printed circuit board (8) into a housing interior (6) enclosed by the housing (3), whereby a positive connection geometry (15) formed on the housing (3) and a counter-positive connection geometry (17) formed on the printed circuit board (8) engage frictionally with each other to connect the printed circuit board (8) to the housing (3),
- insertion of an elastic element (21) in a housing interior (6) enclosed by the housing (3), whereby on one side the elastic element (21) presses the coil (11) against the housing (3, 14) and on the other side is supported by or attached to the printed circuit board (8) in such a way that the coil (11) is held under elastic pre-tension between the housing (3) and the elastic element (21) by means of the elastic element (21)
- pouring of a sealing compound into the enclosed housing interior (6), in particular a thermoplastic sealing compound or casting resin.

14. Process in accordance with Claim 13, **characterized in that** the elastic element (21) is soldered onto the printed circuit board (8) in a printed circuit board (8) component mounting process.

15. Process in accordance with Claim 14, **characterized in that** the printed circuit board (8) is placed on at least one housing shoulder (34), in particular at least two housing shoulders (34), in particular before the sealing compound (7) is poured into the housing.

## Revendications

1. Détecteur inductif de proximité (1), comprenant au moins
- un boîtier (3) lequel entoure un espace intérieur du boîtier (6),
- une carte de circuit imprimé (8) dotée de composants électroniques (9), laquelle est disposée au sein de l'espace intérieur du boîtier (6),
- un élément détecteur (10), lequel est raccordé électriquement à la carte de circuit imprimé (8) et disposé au sein de l'espace intérieur du boîtier (6), l'élément détecteur (10) étant une bobine (11) et
- la carte de circuit imprimé (8) et / ou l'élément détecteur (10) étant entièrement entouré(e) d'un produit de scellement,
**caractérisé en ce sens que**
la bobine (11) est maintenue élastiquement précontrainte au moyen d'un élément élastique (21) entre le boîtier (3) et l'élément élastique (21), l'élément élastique (21) étant disposé dans le boîtier (3) de telle sorte qu'il appuie sur le boîtier (3,14) sur un côté de la bobine (11) et que de l'autre côté il soit maintenu soutenu ou fixé à la carte de circuit imprimé (8), de sorte que la bobine (11) soit raccordée par force avec le boîtier (3) et maintenue en position au sein de l'espace intérieur du boîtier (6).

2. Détecteur inductif de proximité selon la revendication 1, **caractérisé en ce sens que** l'élément élastique (2) est conçu sous forme de ressort (22).

3. Détecteur inductif de proximité selon l'une des revendications précédentes, **caractérisé en ce sens que** l'élément élastique (21) est raccordé et maintenu à la carte de circuit imprimé (8), de préférence par une connexion soudée.

4. Détecteur inductif de proximité selon l'une des revendications précédentes, **caractérisé en ce sens que** l'élément élastique (21) est exécuté comme étant conducteur d'électricité et conçu pour réaliser un raccordement électrique de la bobine (11) avec la carte de circuit imprimé (8).

5. Détecteur inductif de proximité selon l'une des revendications précédentes, **caractérisé en ce sens que** la bobine (11), à sa première extrémité (32), repose directement ou indirectement sur le boîtier (3), en particulier sur un bouchon (14), et, compte tenu de la géométrie du boîtier (3), de préférence sous forme de cavité (23), la bobine (11) est maintenue au boîtier (3) par liaison à conjugaison de forme, l'élément élastique (21) à la seconde extrémité (33) reposant directement ou indirectement sur la bobine (11), la première et la seconde extrémité (32, 33) étant agencées pour se faire face sur la bobine (11),
la bobine (11) comprenant de préférence deux éléments de contact (25) pour le raccordement électrique de la bobine (11), et les éléments de contact (25) étant raccordés électriquement à la carte de circuit imprimé (8) par conjugaison de matière, par connexion soudée par exemple, en particulier aux éléments de contact de la carte de circuit imprimé (19).

6. Détecteur inductif de proximité selon l'une des revendications précédentes, **caractérisé en ce sens que** la carte de circuit imprimé (8) est reliée par force au boîtier (3).

7. Détecteur inductif de proximité selon la revendication 6, **caractérisé en ce sens que,** sur le boîtier, il se forme une géométrie à liaison par conjugaison de forme (15) et sur la carte de circuit imprimé (8) au moins une géométrie à liaison par conjugaison de forme contraire (17), et que ladite au moins une géométrie à liaison par conjugaison de forme ou de forme contraire (15, 17) se mette en prise par force pour raccorder la carte de circuit imprimé (8) au boîtier (3).

8. Détecteur inductif de proximité selon la revendication 7, **caractérisé en ce sens que** la géométrie à liaison par conjugaison de forme (15) est conçue sous la forme d'une came de liaison (16) et / ou d'un épaulement à encoche.

9. Détecteur inductif de proximité selon la revendication 7, **caractérisé en ce sens que** la géométrie à liaison par conjugaison de forme contraire (17) est conçue sous la forme d'une ouverture (18) et / ou d'un épaulement à encoche.

10. Détecteur inductif de proximité selon la revendication 7, **caractérisé en ce sens que** la liaison par force est assurée par assemblage par pressage d'une géométrie à liaison par conjugaison de forme (15) et d'une géométrie à liaison par conjugaison de forme contraire (17).

11. Détecteur inductif de proximité selon la revendication 10, **caractérisé en ce sens que** sur au moins une géométrie à liaison par conjugaison de forme contraire (17), un élément de contact électrique de carte de circuit imprimé (19), de préférence une bague en métal (20), soit respectivement formé sur au moins une géométrie à liaison par conjugaison de forme (15) pour le raccordement électrique conducteur de la carte de circuit imprimé (8) avec le boîtier (3).

12. Détecteur inductif de proximité selon l'une ou plusieurs des revendications précédentes, **caractérisé en ce sens que** le détecteur comprend un conducteur optique (28) et un émetteur de lumière, de sorte que, depuis l'émetteur de lumière et à travers le conducteur optique (28), la lumière générée par l'émetteur de lumière puisse être dirigée hors du détecteur (1), et que de préférence le conducteur optique (28) soit disposé à l'extérieur sur deux ou trois côtés du détecteur (1) de sorte que la lumière émise par l'émetteur de lumière soit visible sur deux ou trois côtés du détecteur (1).

13. Procédé de fabrication d'un détecteur inductif de proximité (1), selon une ou plusieurs des revendications précédentes, comprenant au moins les étapes suivantes :
- fournir un boîtier (3),
- fournir une carte de circuit imprimé (8) dotée de composants électroniques (9),
- fournir un élément détecteur (10), l'élément détecteur étant une bobine (11),
- introduire la bobine (11) au sein de l'un des espaces intérieurs (6) entourés par le boîtier (3), la bobine (11), à une extrémité (32) reposant directement ou indirectement sur le boîtier (3), en particulier sur un bouchon (14), et, compte tenu de la géométrie du boîtier (3), de préférence sous forme de cavité (23), la bobine (11) étant maintenue au boîtier (3) par liaison à conjugaison de forme.
- introduire la carte de circuit imprimé (8) dans l'un des espaces intérieurs (6) entourés par le boîtier (3), une géométrie à liaison par conjugaison de forme (15) formée sur le boîtier et une géométrie à liaison par conjugaison de forme contraire (17) sur la carte de circuit imprimé (8) se mettant en prise par force pour raccorder la carte de circuit imprimé (8) au boîtier (3).
- introduire un élément élastique (21) dans l'un des espaces intérieurs (6) entourés par le boîtier (3), l'élément élastique (21) sur un côté de la bobine (11) appuyant sur le boîtier (3,14) d'un côté de la bobine (11) et, de l'autre côté, étant maintenu soutenu ou fixé à la carte de circuit imprimé (8), de sorte que la bobine (11) soit maintenue élastiquement précontrainte au moyen de l'élément élastique (21) entre le boîtier (3) et l'élément élastique (21)
- sceller l'espace intérieur du boîtier (6) entouré avec un produit de scellement, en particulier un produit de scellement thermoplastique ou une résine de coulée.

14. Procédé selon la revendication 13, **caractérisé en ce sens que** l'élément élastique (21) est brasé sur la carte de circuit imprimé (8) lors d'un processus d'équipement de la carte de circuit imprimé (8).

15. Procédé selon la revendication 14, caractérisé en ce sens que la carte de circuit imprimé (8) est posée sur au moins un épaulement du boîtier (34), en particulier au moins deux épaulements du boîtier (34), en particulier avant un scellement dans un produit de scellement (7).
